# FASCICULE DE BREVET EUROPEEN

(11) **EP 4 052 098 B1**
(45) Date de publication et mention de la délivrance du brevet: **08.11.2023**
(21) Numéro de dépôt: 21712907.1
(22) Date de dépôt: 16.03.2021
(51) Int. Cl.: G04B 17/04

(54) **PROCEDE DE FABRICATION D'UN COMPOSANT HORLOGER EN SILICIUM**
VERFAHREN ZUR HERSTELLUNG EINER UHRENKOMPONENTE AUS SILIZIUM
METHOD FOR MANUFACTURING A SILICON CLOCK COMPONENT

(30) Priorité: 19.03.2020 EP 20164299
(43) Date de publication de la demande: 07.09.2022
(73) Titulaire: Patek Philippe SA Genève, 1204 Genève (CH)
(72) Inventeur: FOURNIER, Rémy, 2000 Neuchâtel (CH); JEANNERET, Sylvain, 2013 Colombier (CH)
(74) Mandataire: Micheli & Cie SA
(86) Numéro de dépôt international: PCT/IB2021/052156
(87) Numéro de publication internationale: WO 2021/186333

(56) Documents cités:
- EP-A1- 2 843 482
- EP-A1- 3 543 795
- EP-A1- 3 543 796
- EP-A1- 3 865 954

## Description

La présente invention concerne un procédé de fabrication d'un composant horloger en silicium.

Le composant horloger en silicium à fabriquer comprend deux éléments, par exemple deux lames élastiques croisées d'un guidage flexible ou deux dentures superposées, séparés dans la direction de la hauteur du composant par un espace vide.

La demande de brevet EP 2911012 décrit un tel composant, plus précisément un oscillateur horloger, obtenu de manière monolithique par gravure profonde et dans lequel les deux éléments, en l'occurrence deux lames élastiques croisées guidant la rotation du balancier de l'oscillateur, ne sont séparés que de quelques microns. La distance séparant les deux éléments est encore réduite si l'on revêt l'oscillateur d'une couche de compensation thermique en oxyde de silicium, comme le propose cette demande de brevet.

Avec un si faible écartement des deux éléments, ces derniers peuvent se toucher pendant le fonctionnement du composant, notamment lors de mouvements au porté, et réduire la précision de la montre. Ils peuvent également se heurter et se détériorer lors de chocs reçus par la montre.

La demande de brevet WO 2015/033238 décrit un mobile horloger à rattrapage de jeu comprenant une première serge dentée reliée rigidement à un moyeu et une deuxième serge dentée reliée par des bras élastiques au moyeu. Ce composant est fabriqué par gravure des deux faces d'une plaque de type silicium sur isolant (SOI) et par enlèvement de la couche intermédiaire d'oxyde de silicium, sauf au niveau du moyeu, pour libérer la deuxième serge et les bras élastiques de la première serge. Dans ce composant, les deux éléments que constituent les serges dentées sont séparés d'une distance correspondant à la hauteur de la couche intermédiaire d'oxyde de silicium, soit au plus 3 µm. Ils peuvent donc se heurter et s'abîmer lors de chocs reçus par la montre.

Dans le cas d'un composant horloger en silicium entièrement rigide, avec par exemple deux éléments du type dentures ou autres éléments d'interaction séparés en hauteur, une trop grande proximité des deux éléments nécessite de placer les pièces respectives avec lesquels ils coopèrent de manière très proche l'une de l'autre, ce qui complique le montage.

Pour éviter les problèmes susmentionnés, on peut augmenter l'écartement des deux éléments par une technique de sous-gravure mais alors la qualité géométrique et dimensionnelle desdits éléments n'est plus garantie. On peut aussi réaliser le composant en deux parties collées ou soudées, séparées par une entretoise qui maintient une distance suffisante entre les deux éléments. Cependant, dans ce cas, on perd l'avantage de la fabrication monolithique, un parfait alignement des parties collées ou soudées étant difficile à obtenir.

Il existe donc un besoin d'un procédé de fabrication d'un composant horloger en silicium permettant d'augmenter à souhait l'écartement en hauteur de deux de ses éléments sans nuire à la précision de fabrication.

On connaît la demande de brevet EP 3865954, opposable au titre de l'article 54(3) CBE.

Le besoin précité est satisfait selon la présente invention par un procédé de fabrication d'un composant horloger selon la revendication indépendante 1. Des réalisations préférées sont définies dans les revendications dépendantes.

Le procédé selon l'invention comprend les étapes suivantes :
a) se munir d'une plaque comprenant une première couche de silicium, une deuxième couche de silicium et, entre les deux, une couche intermédiaire d'oxyde de silicium ;
b) graver la première couche de silicium pour y former une première partie du composant horloger et la deuxième couche de silicium pour y former une deuxième partie du composant horloger ;
c) éliminer la couche intermédiaire d'oxyde de silicium entre un élément de la première partie et un élément de la deuxième partie ; et est caractérisé notamment en ce qu'il comprend au moins les étapes supplémentaires suivantes :
   d) oxyder thermiquement lesdits éléments sans que ceux-ci en viennent à se toucher, puis désoxyder lesdits éléments ;
   e) répéter l'étape d) une ou plusieurs fois jusqu'à obtenir une distance prédéterminée entre lesdits éléments.

Lorsqu'une pièce ou partie en silicium est oxydée thermiquement, la couche d'oxyde de silicium qui apparaît à sa surface se forme en consommant du silicium sur une profondeur correspondant à 44% de son épaisseur. Après avoir éliminé la couche d'oxyde de silicium, il reste donc une pièce ou partie en silicium de taille réduite. Dans la présente invention, en diminuant la taille des deux éléments du composant horloger on augmente leur écartement. De plus, en effectuant les opérations d'oxydation - désoxydation sans que les deux éléments en viennent à se toucher pendant l'oxydation, c'est-à-dire sans que la couche d'oxyde autour du premier élément et la couche d'oxyde autour du deuxième élément, en croissant, se rejoignent, on évite que les deux éléments fusionnent pendant la désoxydation et rendent le composant inopérant.

On connaît dans la technique antérieure des procédés mettant en oeuvre plusieurs séquences d'oxydation - désoxydation (cf. EP 3181938, WO 2019/166922, WO 2019/180596, EP 3416001) mais il s'agit toujours de procédés destinés à régler la raideur d'un spiral ou la fréquence d'un oscillateur et les séquences d'oxydation - désoxydation n'ont jamais pour but d'augmenter l'écartement de deux éléments d'un composant horloger.

D'autres caractéristiques et avantages de la présente invention apparaîtront à la lecture de la description détaillée suivante faite en référence aux dessins annexés dans lesquels :
- la figure 1 est une vue en perspective d'un oscillateur horloger à guidage flexible fabriqué par le procédé selon l'invention ;
- les figures 2 à 7 montrent schématiquement des étapes successives du procédé de fabrication selon l'invention.

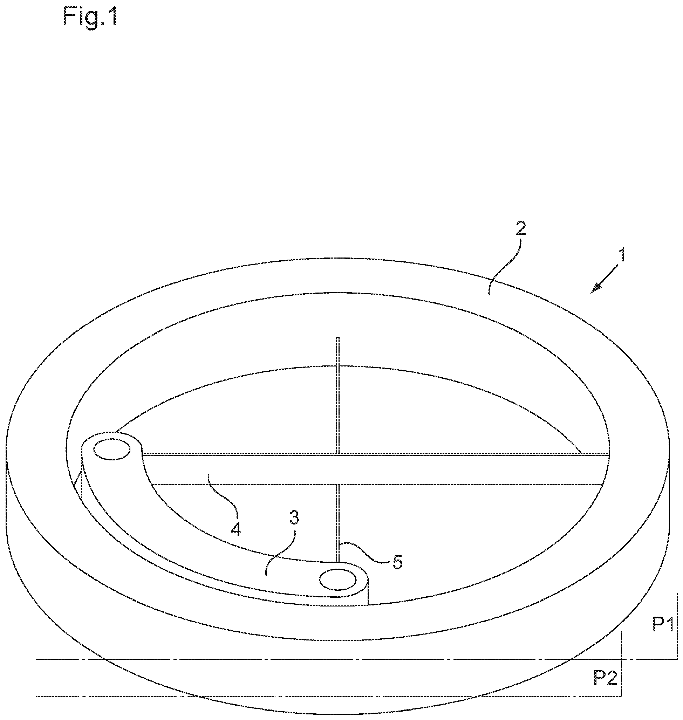

A la figure 1 est illustré un oscillateur horloger à guidage flexible 1 comprenant un balancier 2 suspendu à un support 3 par deux lames élastiques croisées 4, 5. Les lames 4, 5 s'étendent dans deux plans différents P1, P2 parallèles au plan du balancier 2 et se croisent donc à une certaine distance l'une de l'autre. Le croisement des lames 4, 5 définit un axe de rotation virtuel du balancier 2 par rapport au support 3.

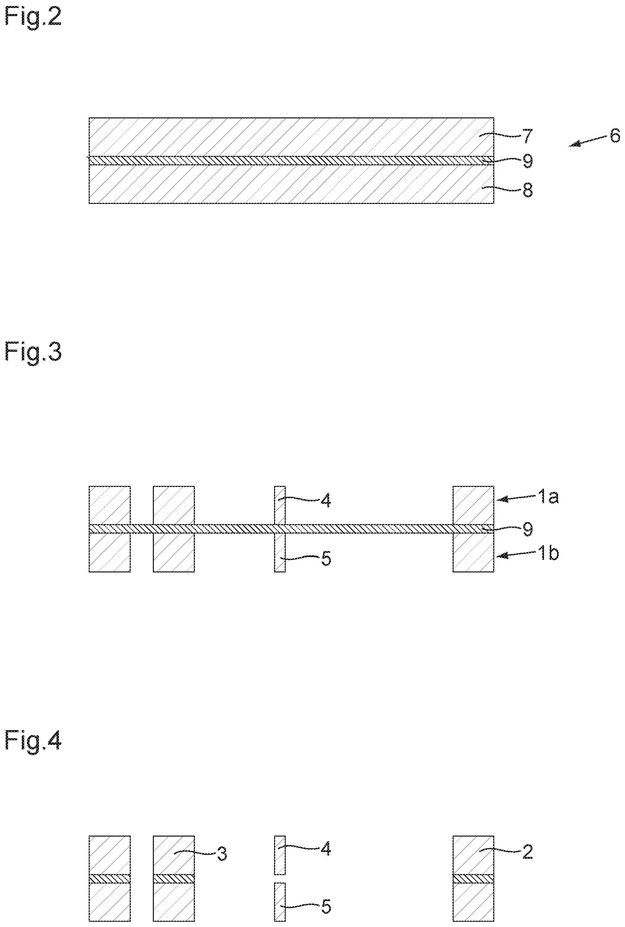

Le procédé selon l'invention permettant de réaliser cet oscillateur horloger avec une distance suffisante entre les lames 4, 5 et avec une grande précision de fabrication est représenté aux figures 2 à 7.

On se munit d'abord d'une plaque (wafer) 6 de type substrat sur isolant comprenant une couche supérieure de silicium 7 et une couche inférieure de silicium 8 séparées par une couche intermédiaire d'oxyde de silicium (SiO₂) 9 (figure 2). Le silicium peut être monocristallin, quelle que soit son orientation cristalline, polycristallin ou amorphe. Il peut être dopé ou non. L'épaisseur de la couche intermédiaire d'oxyde de silicium 9 est typiquement de 3 µm.

La plaque 6 est ensuite gravée successivement ou simultanément des deux côtés (figure 3) pour former une première partie 1a de l'oscillateur 1 dans la couche supérieure de silicium 7 et une deuxième partie 1b de l'oscillateur 1 dans la couche inférieure de silicium 8. Chaque partie 1a, 1b peut être en un seul niveau, comme représenté sur le dessin, ou en plusieurs niveaux.

Dans la première partie 1a de l'oscillateur 1 se trouve l'une, 4, des deux lames élastiques croisées ainsi qu'une partie supérieure du balancier 2 et du support 3. Dans la deuxième partie 1b de l'oscillateur 1 se trouve l'autre, 5, des deux lames élastiques croisées ainsi qu'une partie inférieure du balancier 2 et du support 3.

A ce stade, les deux parties 1a, 1b de l'oscillateur 1 sont séparées par la couche intermédiaire d'oxyde de silicium 9 qui sert à arrêter la gravure. La gravure est typiquement une gravure ionique réactive profonde dite DRIE.

Puis on élimine, par exemple par attaque chimique à l'acide fluorhydrique, la couche intermédiaire d'oxyde de silicium 9 dans certaines zones, notamment entre les deux lames 4, 5, et on la laisse uniquement dans les zones où les première et deuxième parties 1a, 1b de l'oscillateur 1 doivent rester solidaires, à savoir au niveau du balancier 2 et du support 3 (figure 4). Cette étape désolidarise les lames 4, 5, pour qu'elles puissent se déformer l'une par rapport à l'autre.

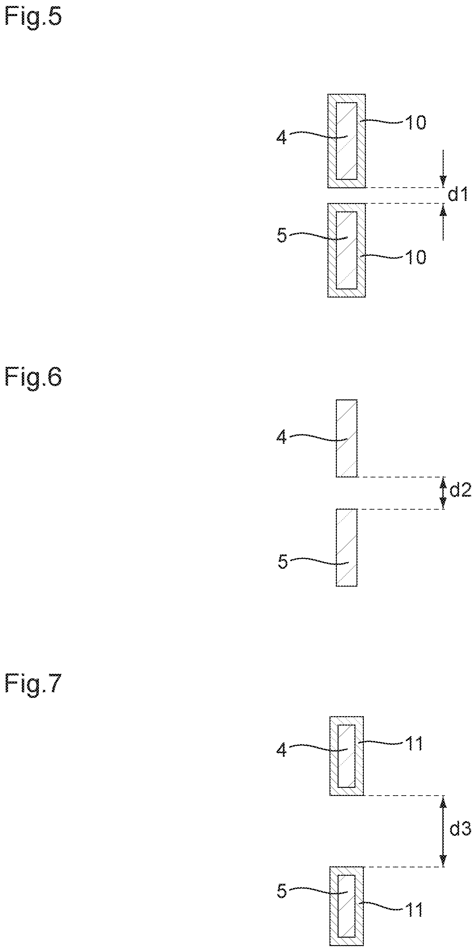

A une étape suivante (figure 5), on oxyde thermiquement l'oscillateur 1 pour que se forme autour de lui, et en particulier autour des lames 4, 5, une couche d'oxyde de silicium 10. Cette couche d'oxyde de silicium 10 se forme au détriment du silicium dont la surface recule. L'oxydation est typiquement réalisée à une température comprise entre 800 et 1200°C sous atmosphère oxydante à l'aide de vapeur d'eau ou de gaz de dioxygène. Elle peut être réalisée de manière localisée, par exemple uniquement sur les lames 4, 5, au moyen de masques tels que des masques de nitrure.

L'oxydation est arrêtée avant que la croissance de la couche d'oxyde de silicium 10 sur les lames 4, 5 conduise les lames 4, 5 à se toucher. Ainsi, une distance d1 sépare encore les lames 4, 5 après l'oxydation.

On désoxyde ensuite l'oscillateur en éliminant la couche d'oxyde de silicium 10, par exemple par attaque chimique à l'acide fluorhydrique (figure 6). La taille des lames 4, 5 est alors réduite, donc la distance d2 qui les sépare est augmentée par rapport à la figure 4.

Puis la séquence d'oxydation - désoxydation illustrée aux figures 5 et 6 est répétée un nombre N de fois afin d'obtenir une distance d2 prédéterminée entre les lames 4, 5. Le nombre N est typiquement au moins égal à 2, de préférence au moins égal à 3, de préférence au moins égal à 4, de préférence au moins égal à 5, de préférence au moins égal à 6, de préférence au moins égal à 7. La distance d2 à l'issue de toutes les séquences d'oxydation - désoxydation est typiquement d'au moins 7 µm, de préférence d'au moins 9 µm, de préférence d'au moins 11 µm, de préférence d'au moins 13 µm, de préférence d'au moins 15 µm. A chaque oxydation - désoxydation, la distance d2 augmente par exemple d'une valeur comprise entre 1 µm et 3 µm.

Les paramètres d'oxydation peuvent varier d'une séquence d'oxydation - désoxydation à la suivante. Par exemple, on peut oxyder l'oscillateur 1 plus longtemps dans les dernières séquences que dans les premières puisque plus d'espace est disponible entre les lames 4, 5 pour la croissance de l'oxyde de silicium.

Chaque étape d'oxydation est arrêtée avant que les lames 4, 5 se touchent (figure 5). De la sorte, on supprime le risque que les lames 4, 5 soient attirées l'une vers l'autre et fusionnent lors de l'élimination de la couche d'oxyde 10.

Après toutes les séquences d'oxydation - désoxydation, une couche finale d'oxyde de silicium 11 peut être formée sur tout l'oscillateur 1 ou au moins sur les lames 4, 5 (figure 7), par oxydation thermique ou dépôt, pour augmenter sa résistance mécanique et rendre sa fréquence moins sensible aux variations thermiques. De préférence, la distance d3 entre les lames 4, 5 après la formation de cette couche finale 11 est d'au moins 5 µm, de préférence d'au moins 7 µm, de préférence d'au moins 9 µm, de préférence d'au moins 11 µm, de préférence d'au moins 13 µm.

De préférence, les séquences d'oxydation - désoxydation et la formation de la couche finale d'oxyde de silicium 11 sont mises en oeuvre alors que l'oscillateur 1 est encore attaché à la plaque 6 par des ponts de matière en silicium laissés lors de la gravure. Une dernière étape du procédé consiste alors à détacher l'oscillateur 1 de la plaque 6 par rupture ou élimination des ponts de matière. On notera que le détachement de l'oscillateur 1 par rupture des ponts de matière est facilité par les oxydations - désoxydations qui l'ont précédé et qui ont supprimé une bonne partie des défauts créés dans la maille cristalline du silicium par le plasma de gravure.

L'oscillateur 1 peut faire partie d'un lot d'oscillateurs identiques fabriqués simultanément dans la plaque 6.

La présente invention n'est pas limitée à la fabrication d'un oscillateur à balancier. Elle peut s'appliquer de la même manière à d'autres types de composants horlogers tels que levier, bascule, ancre, râteau, doigt, roue ou organe moteur. Comme pour l'oscillateur, les deux éléments dont on cherche à augmenter l'écartement peuvent être des lames élastiques croisées servant à guider la partie mobile du composant. Les deux éléments peuvent aussi être des éléments d'interaction avec d'autres pièces, par exemple la fourchette et le dard d'une ancre, deux dentures superposées d'une roue ou d'un râteau, deux protubérances superposées d'un doigt, etc. L'invention peut s'appliquer en particulier à la roue à rattrapage de jeu décrite dans la demande de brevet WO 2015/033238 ou à l'organe moteur décrit dans la demande de brevet WO 2018/146639.

Par ailleurs, la plaque dans laquelle est réalisé le composant horloger selon l'invention pourrait être un substrat sur isolant multiple, c'est-à-dire comprenant plus de deux couches de silicium séparées par des couches intermédiaires d'oxyde de silicium. Dans ce cas, le nombre d'éléments dont on souhaite augmenter l'écartement pourrait être supérieur à deux.

## Revendications

1. Procédé de fabrication d'un composant horloger (1) comprenant les étapes suivantes :
a) se munir d'une plaque (6) comprenant une première couche de silicium (7), une deuxième couche de silicium (8) et, entre les deux, une couche intermédiaire d'oxyde de silicium (9) ;
b) graver la première couche de silicium (7) pour y former une première partie (1a) du composant horloger (1) et la deuxième couche de silicium (8) pour y former une deuxième partie (1b) du composant horloger (1) ;
c) éliminer la couche intermédiaire d'oxyde de silicium (9) entre un élément (4) de la première partie (1a) et un élément (5) de la deuxième partie (1b) ;
**caractérisé en ce qu'**il comprend les étapes supplémentaires suivantes :
d) oxyder thermiquement lesdits éléments (4, 5) sans que ceux-ci en viennent à se toucher, puis désoxyder lesdits éléments (4, 5) ;
e) répéter l'étape d) une ou plusieurs fois jusqu'à obtenir une distance prédéterminée (d2) entre lesdits éléments (4, 5) ;
et **en ce qu'**il comprend au moins une des caractéristiques (i) à (v) suivantes :
(i) lesdits éléments (4, 5) sont deux lames élastiques croisées et l'oxydation de l'étape d) conduit à la formation d'une couche d'oxyde de silicium (10) autour desdites lames ;
(ii) les étapes d) et e) sont mises en oeuvre alors que le composant horloger (1) est encore attaché à la plaque (6) par des ponts de matière en silicium laissés lors de la gravure ;
(iii) la couche intermédiaire d'oxyde de silicium (9) a une épaisseur de 3 µm ;
(iv) la plaque (6) est un substrat sur isolant multiple ;
(v) le composant horloger est un levier, une bascule, un râteau, un doigt ou une roue.

2. Procédé selon la revendication 1, **caractérisé en ce que** la distance prédéterminée (d2) est d'au moins 7 µm, de préférence d'au moins 9 µm, de préférence d'au moins 11 µm, de préférence d'au moins 13 µm, de préférence d'au moins 15 µm.

3. Procédé selon la revendication 1 ou 2, **caractérisé en ce que** l'étape e) consiste à répéter au moins deux fois, de préférence au moins trois fois, de préférence au moins quatre fois, de préférence au moins cinq fois, de préférence au moins six fois, de préférence au moins sept fois l'étape d).

4. Procédé selon l'une quelconque des revendications 1 à 3, **caractérisé en ce que** l'étape d) consiste à oxyder thermiquement puis désoxyder tout le composant horloger (1).

5. Procédé selon l'une quelconque des revendications 1 à 4, **caractérisé en ce qu'**il comprend, après l'étape e), une étape consistant à :
f) former une couche d'oxyde de silicium (11) sur lesdits éléments (4, 5) et de préférence sur tout le composant horloger (1).

6. Procédé selon la revendication 5, **caractérisé en ce que** la distance (d3) entre lesdits éléments (4, 5) à la fin de l'étape f) est d'au moins 5 µm, de préférence d'au moins 7 µm, de préférence d'au moins 9 µm, de préférence d'au moins 11 µm, de préférence d'au moins 13 µm.

7. Procédé selon l'une quelconque des revendications 1 à 6, **caractérisé en ce que** lesdits éléments (4, 5) sont deux lames élastiques croisées.

8. Procédé selon l'une quelconque des revendications 1 à 7, **caractérisé en ce que** le composant horloger est un oscillateur (1), un levier, une bascule, une ancre, un râteau, un doigt, une roue ou un organe moteur.

## Patentansprüche

1. Verfahren zur Herstellung einer Uhrenkomponente (1), das die folgenden Schritte umfasst:
a) Bereitstellen einer Platte (6), die eine erste Siliziumschicht (7), eine zweite Siliziumschicht (8) und zwischen den beiden eine Siliziumoxid-Zwischenschicht (9) umfasst;
b) Ätzen der ersten Siliziumschicht (7), um darin einen ersten Teil (1a) der Uhrenkomponente (1) zu bilden, und der zweiten Siliziumschicht (8), um darin einen zweiten Teil (1b) der Uhrenkomponente (1) zu bilden;
c) Beseitigen der Siliziumoxid-Zwischenschicht (9) zwischen einem Element (4) des ersten Teils (1a) und einem Element (5) des zweiten Teils (1b);
**dadurch gekennzeichnet, dass** es die folgenden zusätzlichen Schritte umfasst:
d) thermisches Oxidieren der Elemente (4, 5), ohne dass diese dabei miteinander in Berührung gelangen, dann Desoxidieren der Elemente (4, 5);
e) ein- oder mehrmaliges Wiederholen des Schritts d), bis ein vorbestimmter Abstand (d2) zwischen den Elementen (4, 5) erhalten wird;
und dadurch, dass es mindestens eine der folgenden Eigenschaften (i) bis (v) umfasst:
(i) die Elemente (4, 5) sind zwei gekreuzte elastische Klingen und die Oxidation des Schritts d) führt zur Bildung einer Siliziumoxidschicht (10) um die Klingen herum;
(ii) die Schritte d) und e) werden durchgeführt, während die Uhrenkomponente (1) noch durch Materialbrücken aus Silizium, die beim Ätzen hinterlassen wurden, an der Platte (6) befestigt ist;
(iii) die Siliziumoxid-Zwischenschicht (9) weist eine Dicke von 3 µm auf;
(iv) die Platte (6) ist ein mehrfach Substrat auf Isolator;
(v) die Uhrenkomponente ist ein Hebel, eine Wippe, ein Rechen, ein Finger oder ein Rad.

2. Verfahren nach Anspruch 1, **dadurch gekennzeichnet, dass** der vorbestimmte Abstand (d2) mindestens 7 µm, vorzugsweise mindestens 9 µm, vorzugsweise mindestens 11 µm, vorzugsweise mindestens 13 µm, vorzugsweise mindestens 15 µm beträgt.

3. Verfahren nach Anspruch 1 oder 2, **dadurch gekennzeichnet, dass** der Schritt e) darin besteht, den Schritt d) mindestens zwei Mal, vorzugsweise mindestens drei Mal, vorzugsweise mindestens vier Mal, vorzugsweise mindestens fünf Mal, vorzugsweise mindestens sechs Mal, vorzugsweise mindestens sieben Mal zu wiederholen.

4. Verfahren nach einem der Ansprüche 1 bis 3, **dadurch gekennzeichnet, dass** der Schritt d) im thermischen Oxidieren und dann Desoxidieren der gesamten Uhrenkomponente (1) besteht.

5. Verfahren nach einem der Ansprüche 1 bis 4, **dadurch gekennzeichnet, dass** es nach dem Schritt e) einen Schritt umfasst, der in Folgendem besteht:
f) Bilden einer Siliziumoxidschicht (11) auf den Elementen (4, 5) und vorzugsweise auf der gesamten Uhrenkomponente (1).

6. Verfahren nach Anspruch 5, **dadurch gekennzeichnet, dass** der Abstand (d3) zwischen den Elementen (4, 5) am Ende des Schritts f) mindestens 5 µm, vorzugsweise mindestens 7 µm, vorzugsweise mindestens 9 µm, vorzugsweise mindestens 11 µm, vorzugsweise mindestens 13 µm beträgt.

7. Verfahren nach einem der Ansprüche 1 bis 6, **dadurch gekennzeichnet, dass** die Elemente (4, 5) zwei gekreuzte elastische Klingen sind.

8. Verfahren nach einem der Ansprüche 1 bis 7, **dadurch gekennzeichnet, dass** die Uhrenkomponente ein Oszillator (1), ein Hebel, eine Wippe, ein Anker, ein Rechen, ein Finger, ein Rad oder ein Antriebsorgan ist.

## Claims

1. Method for manufacturing a horological component (1) comprising the following steps:
a) providing a wafer (6) comprising a first silicon layer (7), a second silicon layer (8) and, in between, an intermediate silicon oxide layer (9);
b) etching the first silicon layer (7) to form therein a first part (1a) of the horological component (1) and the second silicon layer (8) to form therein a second part (1b) of the horological component (1);
c) eliminating the intermediate silicon oxide layer (9) between an element (4) of the first part (1a) and an element (5) of the second part (1b);
**characterised in that** it comprises the following additional steps:
d) thermally oxidising said elements (4, 5) without them coming into contact with each other, and then deoxidising said elements (4, 5);
e) repeating step d) one or more times until a predetermined distance (d2) between said elements (4, 5) is obtained;
and **in that** it comprises at least one of the following features (i) to (v):
(i) said elements (4, 5) are two crossed elastic blades and the oxidation of step d) leads to the formation of a silicon oxide layer (10) around said blades;
(ii) steps d) and e) are carried out while the horological component (1) is still attached to the wafer (6) by silicon material bridges left during etching;
(iii) the intermediate silicon oxide layer (9) has a thickness of 3 µm;
(iv) the wafer (6) is a multiple substrate on insulator;
(v) the horological component is a lever, a rocker, a rake, a finger or a wheel.

2. Method according to claim 1, **characterised in that** the predetermined distance (d2) is at least 7 µm, preferably at least 9 µm, preferably at least 11 µm, preferably at least 13 µm, preferably at least 15 µm.

3. Method according to claim 1 or 2, **characterised in that** step e) consists in repeating at least twice, preferably at least three times, preferably at least four times, preferably at least five times, preferably at least six times, preferably at least seven times step d).

4. Method according to any one of claims 1 to 3, **characterised in that** step d) consists in thermally oxidising and then deoxidising the entire horological component (1).

5. Method according to any one of claims 1 to 4, **characterised in that** it comprises, after step e), a step consisting in:
f) forming a silicon oxide layer (11) on said elements (4, 5) and preferably on the entire horological component (1).

6. Method according to claim 5, **characterised in that** the distance (d3) between said elements (4, 5) at the end of step f) is at least 5 µm, preferably at least 7 µm, preferably at least 9 µm, preferably at least 11 µm, preferably at least 13 µm.

7. Method according to any one of claims 1 to 6, **characterised in that** said elements (4, 5) are two crossed elastic blades.

8. Method according to any one of claims 1 to 7, **characterised in that** the horological component is an oscillator (1), a lever, a rocker, an anchor, a rake, a finger, a wheel or a motor member.
